# EUROPEAN PATENT APPLICATION

(11) **EP 1 795 284 A1**
(43) Date of publication of application: **13.06.2007**
(21) Application number: 05766215.7
(22) Date of filing: 15.07.2005
(51) Int. Cl.: B22F 1/02, B22F 1/00, C23C 18/18, C23C 18/34, H01B 5/00, H01B 1/22

(54) **NICKEL COATED COPPER POWDER AND PROCESS FOR PRODUCING THE SAME**

(30) Priority: 22.07.2004 JP 2004213757
(71) Applicant: MITSUI MINING & SMELTING CO., LTD., Tokyo 141-8584 (JP)
(72) Inventor: SAKAUE, Takahiko c/o Hikoshima Smelting Co., Ltd., Shimonoseki-shi, Yamaguchi 7500093 (JP); FURUMOTO, Keita c/o Hikoshima Smelting Co., Ltd., Shimonoseki-shi, Yamaguchi 7500093 (JP); YOSHIMARU, K. c/o Hikoshima Smelting Co., Ltd., Shimonoseki-shi, Yamaguchi 7500093 (JP)
(74) Representative: Bohmann, Armin K.
(86) International application number: PCT/JP2005/013122
(87) International publication number: WO 2006/009097

(57) **Abstract**

Objects of the present invention are to provide oxidation resistant nickel-coated copper powder for conductive paste capable of forming a conductive wiring part for an electronic circuit, and to provide a method for producing the same. In order to achieve the objects, there is provided nickel-coated copper powder which is **characterized in that** it comprises nickel-coated copper particles in which a core material is copper particles, a catalyst for plating is fixed to a surface of the copper particles by reduction reaction and electroless plated nickel is applied to the outermost surface. The reduction reaction is **characterized in that** hydrazine is used as a reducing agent.

## Description

### Technical Field

The present invention relates to a nickel-coated copper powder comprising copper particles coated with nickel on the surface thereof (hereinafter referred to as "nickel-coated copper powder"), and to a method for producing the same. More particularly, the present invention relates to the nickel-coated copper powder excellent in oxidation resistance and suitable as a material for conductive paste for wiring an electronic circuit board, and to a method for producing the same.

### Background Art

In recent years, a organic multilayer board has been widely used as an electronic circuit board with the miniaturization and integration of electronic equipment. And as a conductive material for conductive paste to form wiring on the board, copper powder which can keep material cost lower and has excellent electric conductivity has been used as appropriate.

However, while copper has advantages in cost and electric conductivity as described above, it has a drawback in being easily oxidized. This property of being easily oxidized is further accelerated by the particle size reduction of copper. And when copper is used for circuit wiring, the oxidation of copper may reduces the electric conductivity of copper powder to increase the specific resistance. It may leads to loose practical utility of the wiring using the copper. Since miniaturization in circuit wiring is going forward recently, such poor oxidation resistance may not be acceptable because the circuit may fail in the operation.

As described above, when copper powder is used as a material for conductive paste, it is necessary not only to reduce the particle size of copper to a certain limit but also to prevent the oxidation of the fine copper powder in order to prevent the decrease in electric conductivity due to the oxidation of copper.

From such a background, Patent Document 1 discloses the method in which copper powder is immersed in a 5% aqueous palladium chloride solution to activate the surface of the copper powder; the resulting powder is rinsed with water; and then nickel-coated powder is formed in a Ni-B bath solution.

[Patent Document 1] Japanese Patent Laid-Open No. S64-718
[Non-Patent Document 1] "Electroless Plating: Fundamentals and Applications" published by the Nikkan Kogyo Shimbun, Ltd., P. 135

### Disclosure of the Invention

However, Patent Document 1 only discloses a method in which palladium is randomly attached to the surface of the copper particles and then the copper powder is put into an electroless nickel plating bath for a predetermined period of time to apply nickel plating having a thickness of about 0.5 µm to the copper powder. Therefore, the method has drawbacks in that the electroless nickel plating does not fix strongly to the surface of copper particles and the surface of copper particles is unevenly coated with the electroless plated nickel.

On the other hand, Non-patent Document 1 discloses a method for fixing palladium to a surface on which electroless plating is applied. It uses tin which is a metal element as a reducing agent for reducing palladium (metal element). However, the surface on which electroless plating is applied require palladium metal as a catalyst, but a small amount of bivalent and tetravalent tin salts, which are not required, may remain.

Thus, an object of the present invention is to provide a nickel-coated copper powder having superior oxidation resistance which is obtained by using a non-metallic reducing agent to strongly fix a catalyst element to the surface of copper particles.

### Means to solve the problem

As a result of extensive investigations by the present inventors, it has been found that the above object can be achieved by fixing a plating catalyst to the surface of copper particles by reduction reaction using a non-metallic reducing agent and depositing a nickel plating layer thereon by electroless nickel plating, thereby producing nickel-coated copper powder with stable oxidation-resistance. Specifically in a conventional method, it is supposed that since a catalyst, preferably palladium, has attached unstably to the surface of copper particles, the adhesion between the surface of copper particles and a coated nickel layer has also not been strong. However, according to the present invention, a catalyst, preferably palladium has been fixed stably to the surface of copper particles by a reduction method using a non-metallic reducing agent (hydrazine). It may perform strong adhesion between the surface of copper particles and the coated nickel layer. It may mean that this has been verified by the fact that the improvement in adhesion between the catalyst and the surface of copper particles has led to higher TG oxidation starting temperature, which means excellent oxidation resistance.

Nickel-coated copper powder according to the present invention will be described below.

In accordance with the present invention, there is provided a nickel-coated copper powder which is characterized in that the nickel-coated copper powder comprises nickel-coated copper particles comprising copper particles as a core material, a catalyst for plating is fixed to a surface of the copper particles by reduction reaction, and electroless plated nickel is applied on the catalyst.

As used herein "catalyst" refers to a substance which performs increasing the reaction rate or promoting only specific reaction when it is added to a system in which the reaction proceeds thermodynamically but is extremely slow in actuality. In particular, the "catalyst" as described above is required in electroless plating. It is because a plating metal is applied to an object to be plated utilizing only chemical reaction in the electroless plating. So, it is different from electroplating in which a potential is applied to both of an object to be plated and a plating metal to force the plating metal to be electrically plated on the object to be plated. In the case of the present invention, palladium which is generally used as a catalyst (having general-purpose properties) is used as a catalyst element for the electroless plating.

Moreover, "reducing agent" refers to a chemical substance for removing oxygen from an oxide to reduce it to be an element. In the case of the present invention, hydrazine is used as a reducing agent. Hydrazine is a non-metallic reducing agent represented by the chemical formula: NH₂NH₂. It is known that hydrazine is decomposed by a copper catalyst when it is in an aqueous solution (see "Kagaku Daijiten (Encyclopaedia Chimica)" published by Kyoritsu Shuppan Co., Ltd.). In the present invention, hydrazine can be used to deposit palladium, a catalyst for copper, by reduction reaction.

The nickel-coated copper powder preferably has a D₅₀ (µm) of 0.5 to 10. As used herein "D₅₀" refers to the 50% volume cumulative particle size based on a method for measuring the laser diffraction/scattering particle size distribution. Hereinafter, the same notation is used.

The D₅₀ (µm) has the range as described above because when it is less than 0.5 µm, preparation of paste may become difficult because of the oil absorption in the process is too large, thereby the powdered copper is easily oxidized and electric conductivity may fall down. And when it is more than 10 µm, it may cause difficulties in forming the finer electronic circuit wiring on a board.

It should be noted that the nickel-coated copper powder of the present invention is used as a material for the conductive paste (a procedure for the conductive paste (production method) may described later).

Moreover, the shape of the nickel-coated copper powder of the present invention is not particularly limited, it can be of any shape, such as spherical, flaky, or the like.

In accordance with the present invention, an oxidation resistant nickel-coated copper powder can be provided by improving adhesion and uniformity of plated nickel by fixing a plating catalyst to copper particles with good adhesion and uniformity. More specifically, the present invention can provide a nickel-coated copper powder in which, for example, when a ceramic base and a copper paste using this nickel-coated copper powder are simultaneously sintered, copper particles are not oxidized at a binder-removing temperature.

### Best Mode for Carrying Out the Invention

Best mode for carrying out the present invention will be described below.

It goes without saying that, although numerical values or the like for each reagents, each solutions, or the like are shown in the following description, execution of the present invention is not limited to the following numerical values. And the amount of each reagents, each solutions, or the like and other conditions can be appropriately changed by those who skilled in the art depending, for example, on the scales of pilot or mass production.

First, copper-powder slurry is prepared by charging copper powder into water of 30°C to 70°C in an amount such that a mixture of 50 g/L to 500 g/L is obtained, followed by stirring the mixture. It is desirable to use pure water.

Next, to the above copper-powder slurry, a catalyst-forming material containing a plating catalyst element such as palladium is added in an amount of 1×10⁻¹ mol to 5x10⁻³ mol per 1 mol of Cu, and the slurry is stirred for 5 minutes to 60 minutes.

Next, preferably 0.05 mol to 0.3 mol of hydrazine per 1 mol of Cu is added as a reducing agent to deposit and fix the catalyst by reduction reaction to the surface of copper particles. Other than hydrazine, formalin can also be used as a reducing agent.

The above slurry is rinsed by decantation and mixed with the required nickel plating solution to prepare nickel-coated copper powder. The required nickel plating solution is prepared by calculating the requirement from the desired weight of the nickel-coated copper powder. It is calculated from the percent by weight of the nickel coating applied by the electroless nickel plating treatment to be 0.1% to 10% based on 100% by weight of the nickel-coated copper powder.

Then, the nickel-coated copper powder can be heat-treated in a non-oxidizing environment to improve the crystallinity of nickel. For example, heat treatment preferred is, using a closed batch furnace and the like with an environment of 1% hydrogen and 99% nitrogen at 300°C for about one hour.

The nickel-coated copper powder of the present invention may be stored in wetting with an organic solvent. Examples of the organic solvent which can be used for wetting the powder include methanol, ethanol, acetone, methyl ethyl ketone, methyl isobutyl ketone, isobutanol, isopropanol, hexane, toluene, terpineol, butyl carbitol acetate, and the like.

Examples according to the present invention will be described below.

### Example 1

(1) 1 kg of copper powder (D₅₀=5.2 µm) was charged into 5 L of pure water of 50°C, followed by stirring to prepare a copper-powder slurry.
(2) Then, 100 ml of Melplate Activator 352 manufactured by Meltex Inc. was added to the copper-powder slurry, followed by stirring for 10 minutes.
(3) Then, 100 ml of hydrazine hydrate was added to the slurry to deposit palladium on the surface of copper particles.
(4) After stop the stirring of the mixture, 4 L of a supernatant solution was removed.
(5) 4 L of pure water was added to the above slurry, and the mixture was heated up to 50°C. Then a nickel plating solution (an electroless nickel plating solution obtained by adding 1.2 L of Ni-426B to 1.2 L of Ni-426A, both are manufactured by Meltex Inc.) was added to prepare a nickel-coated copper powder in which palladium was fixed to copper particles of the powder.
(6) Then, the resulting mixture was subjected to filtration, rinsing, and drying in the popular manner, thereby obtaining a nickel-coated copper powder according to Example 1.

### Example 2

Nickel-coated copper powder was prepared in the same manner as in Example 1. Therefore, the description thereof is omitted here. However, after the step (6) as described above, the nickel-coated copper powder was subjected to heat treatment in a condition where dispersibility of the powder is not degraded, an environment of 1% hydrogen and 99% nitrogen at 300°C for about one hour. The heat treatment is performed for the purpose of adjusting the crystallinity of nickel by heat-treating the nickel part of the powder. Thus, a nickel-coated copper powder according to Example 2 was obtained.

### Comparative Examples

### (Comparative Example 1)

Copper powder according to Comparative Example 1 is a spherical copper powder itself having a D₅₀ of 5.2 µm (that is, the copper powder of Example 1 as a core material) without any coating thereon.

### (Comparative Example 2)

(1) 1 kg of copper powder (D₅₀=5.2 µm) was charged to a solution prepared by dissolving 160 g of sodium ethylenediaminetetraacetate in 9 L of water, followed by stirring to prepare a copper-powder slurry.
(2) 1 L of a silver nitrate solution (prepared by dissolving 180 g of silver nitrate in 220 mL of an aqueous ammonia solution followed by adding water to obtain an aqueous solution of 1 L) was added to the copper-powder slurry in 30 minutes.
(3) Next, 140 g of Rochelle salt was added to the solution obtained in the step (2), followed by stirring for 30 minutes.
(4) Then, the resulting mixture was subjected to rinsing and drying in the popular manner to obtain a silver-coated copper powder according to Comparative Example 2.

### (Comparative Example 3)

(1) 1 kg of copper powder (D₅₀=5.2 µm) was charged to 5 L of pure water of 50°C, followed by stirring to prepare a copper-powder slurry.
(2) Then, 0.1 L of an activator (Melplate Activator 652 manufactured by Meltex Inc.) and 0.1 L of hydrochloric acid (35% by volume) were added to the above copper-powder slurry, followed by stirring for 10 minutes for activation treatment.
(3) Next, the copper powder after the activation treatment was subjected to solid-liquid separation with a Nutsche, followed by rinsing.
(4) Further, the copper powder after the activation treatment was added to 5 L of pure water, followed by stirring.
(5) A nickel plating solution (an electroless nickel plating solution obtained by adding 1.2 L of Ni-426B to 1.2 L of Ni-426A, both are manufactured by Meltex Inc.) was added to the water containing the copper powder to prepare a nickel-coated copper powder.
(6) Then, the resulting mixture was subjected to rinsing and drying in the popular manner to obtain a nickel-coated copper powder according to Comparative Example 3.
   Table 1 is summary of the evaluation results for Examples and Comparative Examples.

**[Table 1]**

| | Coating to copper | catalyst treatment | Heat treatment after Ni-plating | Migration resistance | TG oxidation starting temperature (a indicator for oxidation resistance) | Specific resistance of powder Ω.cm | |
|---|---|---|---|---|---|---|---|
| | | | | | | Initial value | After 150°C for 24H |
| Example 1 | Ni 5% | New treatment | None | good | 420°C | 8.2 x 10⁻² | 0.57 x 10⁻² |
| | | | | | excellent | good | good |
| Example 2 | Ni 5% | New treatment | Yes | good | 425°C | 4.4 x 10⁻⁴ | 6.7 x 10⁻³ |
| | | | | | excellent | good | good |
| Comparative Example 1 | None | None | None | good | 160°C | 7.9 x 10⁻⁴ | 5.6 x 10⁺³ |
| | | | | | not acceptable | good | not acceptable |
| Comparative Example 2 | Ag 10% | None | None | not acceptable | 180°C | 5.5 x 10⁻⁵ | 8.5 x 10⁻⁴ |
| | | | | | not acceptable | excellent | good |
| Comparative Example 3 | Ni 5% | Conventional treatment | None | good | 340°C | 4.3 x 10⁺¹ | 5.6 x 10⁺³ |
| | | | | | acceptable | not acceptable | not acceptable |

A summary of each evaluation items in Table 1 and the evaluation of Examples 1 and 2 and Comparative Examples 1 to 3 will be described below one by one.
(1) The column "Coating to copper" shows each metals and the percent by weight thereof based on 100% by weight of the entire metal-coated (nickel-coated or silver-coated) copper particles in which the metal is applied to copper particles (the outer most layer) composing the copper powder. The column corresponding to Comparative Example 1 shows "None" because copper powder itself was used.
(2) In the column of "Catalyst treatment", "New treatment" refers to a treatment in which a catalyst is applied to the surface of copper particles by using the reduction method of the present invention; "Conventional" refers to a treatment in which a catalyst is applied to the surface of copper particles by using a adsorption method in the prior art; and "None" refers to performing no catalyst treatment.
(3) The column "Heat treatment" shows the heat treatment which has been described above in detail. Therefore, the description thereof is omitted here.

(4) The column "Migration resistance" shows the results of examinations for evaluating migration resistance of nickel-coated copper powder. The test and evaluation of the migration resistance was performed in the manner as described below.
First, conductive paste prepared by a method to be described later was used to draw straight-line conductor circuits, thereby forming a comb-pattern circuit to be used for evaluating the migration resistance. The straight-line conductor circuits comprise 100 straight circuit lines each having a paste circuit width of 100 µm, an interline gap of 100 µm, and a length of 10 cm. Then comb-pattern circuit comprises 50 straight-line conductor circuits connecting to the anode of the power supply are arranged in parallel with alternately comb-pattern circuit comprises 50 lines connecting to the cathode of the power supply for migration resistance evaluation. Then, the comb-pattern conductor circuit was immersed in a hydrochloric acid solution having a concentration of 10⁻⁶ mol/l in a state where it is connected with a power supply of 1 volt to cause migration. Then the time until a short-circuit current of 50 mA starts flowing between the adjacent straight-line conductor circuits was measured. As a result, the short-circuit current started flowing at 330 seconds only in the case of Comparative Example 2 (silver-coated copper powder), and in the case of Examples 1 and 2 and Comparative Examples 1 and 3, the short-circuit current did not start flowing after 600 seconds, which can be judged as good in migration resistance performance.

### <Method for preparing conductive paste for evaluating migration>

The method for preparing a conductive paste used for evaluating the migration will be noted below.
12.0 g of bisphenol-F epoxy resin (RE-303SL manufactured by Nippon Kayaku Co., Ltd.), 2.1 g of an acid anhydride curing agent (Kayahard MCD manufactured by Nippon Kayaku Co., Ltd.), 0.7 g of an amine adduct curing agent (Amicure MY-24 manufactured by Ajinomoto Fine-Techno Co., Inc.), and 15.2 g of α-terpineol (manufactured by Yasuhara Chemical, Co., Ltd.) as a viscosity controlling agent were kneaded in a paddle-type kneader for 5 minutes, followed by adding each samples powder and further kneading for 10 minutes. Next, after the resulting kneaded products were successively kneaded with a three roll mill, air bubbles contained in the kneaded product was removed using a deaerator (AR-250 manufactured by Thinky Corporation) to obtain the nickel-coated copper powder pastes, those were used as the conductive paste for evaluating the migration resistance.

(5) The column "TG oxidation starting temperature" shows the TG oxidation starting temperature (the temperature where the amount of oxygen starts increasing) of the samples obtained in Examples 1 and 2 and Comparative Examples 1 to 3 which were measured by using a thermogravimetric/differential thermal analyzer (TG-DTA instrument: TG/DTA 6300 manufactured by Seiko Instruments Inc.) in an atmospheric environment with a temperature elevation rate of 10°C/min. The TG oxidation starting temperature was used as an indicator of oxidation resistance. Specifically, it can be judged that the sample with lower starting temperature is easier to be oxidized and the sample with higher starting temperature is harder to be oxidized. From Table 1, it has been found that the samples from Examples 1 and 2 according to the present invention are excellent in oxidation resistance.

(6) The column "Specific resistance of powder" shows the measured values of specific resistance of the powder samples from Examples 1 and 2 and Comparative Examples 1 to 3 in the state of as received and after heating. Each of the powder samples in an amount of 15 g were pressed in 400 kg/cm² using Loresta PD-41 manufactured by Mitsubishi Chemical Corporation to form a cylindrical pellet having a diameter of 25 mm. The pellet without heating was first measured for the initial value of specific resistance using a four-probe resistivity meter (Loresta GP manufactured by Mitsubishi Chemical Corporation). And each of the powder samples after heating were heat-treated at 150°C for 24 hours, followed by preparing a cylindrical pellet having a diameter of 25 mm in the same manner as described above, then specific resistance is measured by using a four-probe resistivity meter.

### <Evaluation of specific resistance>

The specific resistance of the samples from Comparative Example 1 (copper powder without coating) and Comparative Example 3 (catalyst treatment by a conventional adsorption method) after heat treatment was relatively very high, which means that these samples have inferior electric conductivity. On the other hand, the specific resistance of the samples from Examples 1 and 2 (with nickel coating, with catalyst treatment by the reduction method of the present invention) and Comparative Example 2 (silver-coated copper powder) after heat treatment was very low, which means that these samples have superior electric conductivity. These results make it clear that the nickel-coated copper powder according to the present invention has achieved improved oxidation resistance by fixing the catalyst to the copper powder by the reduction method.

### <Overall evaluation>

The samples from Examples 1 and 2 of the present invention were excellent in all evaluation items. The sample from Example 2 was superior in comparison with that from Example 1. This is probably because the crystallinity of nickel has improved by heat treatment and copper and nickel have moderately diffused with each other by a moderate heat treatment, thereby improving the adhesion between them. For practical purposes, the sample from Example 1 without heat treatment is good enough in powder properties. Therefore, it will be preferred that a judgment whether the heat treatment should be performed or not be made in consideration of customer requirement and production cost.

### Industrial Applicability

The nickel-coated copper powder of the present invention and the method for producing the same can be applied to a conductive material for conductive paste for a wiring part produced by low temperature simultaneous baking with a ceramic base material or the like and for an organic multilayer board or the like.

## Claims

1. A nickel-coated copper powder which is **characterized in that** it comprises nickel-coated copper particles comprising:
a core material is copper particles;
a catalyst for plating is fixed to a surface of the copper particles by reduction reaction; and
electroless plated nickel is applied to the outermost surface.

2. The nickel-coated copper powder according to claim 1, which is **characterized in that** hydrazine is used as a reducing agent in the reduction reaction.

3. The nickel-coated copper powder according to claim 1 or 2, which is **characterized in that** the catalyst is palladium.

4. The nickel-coated copper powder according to any one of claims 1 to 3, which is **characterized in that** the powder has a D₅₀ (µm) of 0.5 to 10, wherein D₅₀ represents the 50% volume cumulative particle size based on a method for measuring the laser diffraction/scattering particle size distribution.

5. The nickel-coated copper powder according to any one of claims 1 to 4, which is **characterized in that** the nickel-coated copper powder is heat-treated in a non-oxidizing environment.

6. The nickel-coated copper powder according to any one of claims 1 to 5, which is **characterized in that** the percent by weight of the nickel coating applied by the electroless nickel plating treatment is 0.1% to 10% based on 100% by weight of the nickel-coated copper powder.

7. A conductive paste comprising the nickel-coated copper powder according to any one of claims 1 to 6.

8. A method for producing a nickel-coated copper powder which is **characterized in that** nickel-coated copper powder comprises nickel-coated copper particles, the method comprising the steps of:
fixing a catalyst element for plating to a surface of the copper particles as a core material by reduction reaction; and
carrying out electroless nickel plating to the outermost surface where the catalyst element for plating is fixed to the surface of the copper particles as a core material.
